Europäisches Patentamt

European Patent Office

Office européen des brevets

(11) Veröffentlichungsnummer: **0 243 634 B1**

# (12) EUROPÄISCHE PATENTSCHRIFT

(45) Veröffentlichungstag der Patentschrift: **13.11.91**

(51) Int. Cl.5: **H03K 5/08**

(21) Anmeldenummer: **87103507.7**

(22) Anmeldetag: **11.03.87**

(54) Schaltungsanordnung zur Ansteuerung eines IC-Bausteins mit Digitalsignalen.

(30) Priorität: **14.03.86 DE 3608616**

(43) Veröffentlichungstag der Anmeldung:
**04.11.87 Patentblatt 87/45**

(45) Bekanntmachung des Hinweises auf die
Patenterteilung:
**13.11.91 Patentblatt 91/46**

(84) Benannte Vertragsstaaten:
**AT BE CH DE ES FR GB IT LI NL SE**

(56) Entgegenhaltungen:
**EP-A- 0 239 844**          **DE-A- 2 324 692**
**DE-A- 3 346 725**         **US-A- 3 537 025**
**US-A- 4 242 604**          **US-A- 4 263 555**

**PATENT ABSTRACTS OF JAPAN, Band 8, Nr.
84 (E-239)[1521], 18. April 1984; & JP-A-59
5740**

**IBM Technical Disclosure Bulletin, vol. 11,
no. 10, März 1969, Seiten 1272-1273**

(73) Patentinhaber: **SIEMENS AKTIENGESELL-
SCHAFT**
**Wittelsbacherplatz 2**
**W-8000 München 2(DE)**

(72) Erfinder: **Trumpp, Gerhard, Dipl.-Ing.**
**Mitterlängstrasse 7**
**W-8039 Puchheim(DE)**

EP 0 243 634 B1

## Beschreibung

In der Technik integrierter Digitalschaltungen hat man verschiedene Schaltungstechnologien entwickelt, die jeweils bestimmten, an integrierte Schaltungen zu stellenden Anforderungen in besonderem Maße gerecht werden, dabei aber in der Regel auch mit nachteiligen anderen Eigenschaften behaftet sind. So zeichnet sich etwa die seit langem eingesetzte ECL-Technik besonders durch die Schnelligkeit und die Ansprechempfindlichkeit ihrer Schaltungen aus, was auf der anderen Seite aber mit relativ hohen Verlustleistungen und einer niedrigen Störsicherheit verbunden ist. Hieraus resultiert, daß in bestimmten Anwendungsfällen, etwa bei Leitungstreibern und Leitungsempfängern, die ECL-Technik derzeit kaum zu ersetzen ist, daß zugleich aber die Tendenz dahin geht, zumindest andere Schaltungsteile auch mit (hoch)integrierten Digitalschaltungen anderer Technologien, z.B. in C-MOS-Technik, zu realisieren, die einerseits auch hinreichend schnell sein können, bei denen andererseits aber der Leistungsbedarf sehr viel kleiner ist. An den Schnittstellen zwischen ECL-Technik und C-MOS-Technik genügt es dann aber noch nicht, lediglich schnelle Eingangsschaltungen, beispielsweise C-MOS-Inverter, vorzusehen; solchen schnellen C-MOS-Eingangsschaltungen müssen vielmehr auch die richtigen Digitalsignalpegel zugeführt werden. Dies kann durch einen entsprechenden Pegelabgleich in einer Interface-Schaltung bewirkt werden, wobei indessen ein einfacher Pegelabgleich in der Praxis vielfach nicht ausreicht, sondern auch - etwa durch Speisespannungsschwankungen und Temperaturänderungen verursachte - Pegelschwankungen vermieden werden müssen.

Die Erfindung stellt sich demgegenüber die Aufgabe, eine Ansteuerung schneller Eingangsschaltungen eines IC-Bausteins einer Technologie von einem IC-Baustein einer anderen Technologie her zu ermöglichen, ohne daß es jeweils eines Pegelabgleichs und einer Unterdrückung von Spannungs- und Temperaturänderungseinflüssen auf den Digitalsignalpegel bedarf.

Bei einer (aus JP-A-59-5740) bekannten, sicherlich auch zur Ansteuerung eines IC-Bausteins durch Ausgangsdigitalsignale eines anderen IC-Bausteins geeigneten Digitalsignal-Ansteuerschaltung ist eine Eingangsschaltung vorgesehen, deren Schaltschwelle, von einer Steuerschaltung mit einer von einem Digitalsignal beaufschlagten Begrenzerschaltung und einer ihr nachgeschalteten, zu dem Steuereingang der Eingangsschaltung führenden Tiefpaßschaltung gesteuert, nach Maßgabe der in dem Digitalsignal auftretenden Gleichstromkomponente eingestellt wird.

Diese bekannte Ansteuerschaltung sieht nur eine Ansteuerung mit einem einzigen Digitalsignal vor, das dabei zwangsläufig auch noch eine Amplitudenbegrenzung erfährt.

Die Erfindung zeigt demgegenüber einen Weg zu einer Ansteuerung eines IC-Bausteins durch eine Mehrzahl solcher Digitalsignale.

Die Erfindung betrifft eine zur Ansteuerung eines IC-Bausteins durch ein Ausgangs-Digitalsignal eines anderen IC-Bausteins geeignete Schaltungsanordnung mit einer Eingangsschaltung, deren jeweilige Schaltschwelle, von einer Steuerschaltung mit einer von einem Digitalsignal beaufschlagten Begrenzerschaltung und einer ihr nachgeschalteten, zu dem Steuereingang der Eingangsschaltung führenden Tiefpaßschaltung gesteuert, nach Maßgabe der in dem Digitalsignal auftretenden Gleichstromkomponente eingestellt wird; diese Schaltungsanordnung ist erfindungsgemäß dadurch gekennzeichnet, daß zur Ansteuerung des IC-Bausteins durch eine Mehrzahl solcher Digitalsignale für die einzelnen Digitalsignale eine entsprechende Mehrzahl untereinander gleichartiger Eingangsschaltungen vorgesehen ist, die jeweils mit einem in den Digitalsignalweg eingefügten, mit einem Lasttransistor verbundenen Schalttransistor in Gateschaltung gebildet sind, zu dessen Gate-Elektrode eine gemeinsame Steuerschaltung führt, deren Begrenzerschaltung von einem in seinem Signalpegel auch für die übrigen Digitalsignale repräsentativen Digitalsignal beaufschlagt ist.

Ausgehend davon, daß die einen IC-Baustein ansteuernden Ausgangs-Digitalsignale eines anderen IC-Bausteins (oder auch mehrerer solcher IC-Bausteine) miteinander in ihren Signalpegelhöhen im wesentlichen übereinstimmen, so daß insoweit ein Digitalsignal auch für die übrigen Digitalsignale repräsentativ ist, und ausgehend von einem hinreichend konstanten Tastverhältnis ("High"-Bitdauer : "Low"-Bitdauer) und einem innerhalb vorgegebener Grenzen liegenden Verhältnisses von Bitperiodendauer zu Flankenübergangszeit dieses repräsentativen Digitalsignals bringt die Erfindung den Vorteil mit sich, ohne die Signalverläufe (Signalzustände, Tastverhältnisse, Flankenlagen) der übrigen den IC-Baustein ansteuernden Digitalsignale im einzelnen kennen zu müssen, dennoch - etwa speisespannungs- oder temperaturbedingten - Abweichungen dieser Digitalsignale von ihrem Soll-Verlauf durch entsprechendes Nachführen der Arbeitspunkte (Schaltschwellen) der mit diesen Digitalsignalen beaufschlagten Eingangsschaltungen des IC-Bausteins Rechnung tragen und in ihren Auswirkungen somit kompensieren zu können, wobei jeweils die Verschiebung der Schaltschwelle in Verbindung mit der endlichen Flankensteilheit des Digitalsignals die gewünschte Kompensation bewirkt; dabei braucht das Digitalsignal nicht zwangsläufig auch noch eine Amplitudenbegrenzung zu erfahren.

In diesem Zusammenhang sei bemerkt, daß es für einen Schnittstellen-Chip z. B. für einen TTL-MOS-Übergang (aus der US-A 42 42 604) bekannt ist, zur Stabilisierung der Entscheidungsschwelle gegenüber chiptemperaturbedingten Änderungen der Eingangstransistor-Schwellspannung zusätzlich zu mit Eingangssignalen beaufschlagten Eingangsstufen eine mit einer festen Referenzspannung beaufschlagte Referenzstufe vorzusehen, deren Ausgangssignal in dieser Referenzstufe sowie in jeder Eingangsstufe jeweils einen Fußpunkttransistor steuert, so daß sich dessen Widerstand derart ändert, daß das Source-Potential des jeweiligen Eingangstranistors gegensinnig zu dessen Schwellspannung geändert wird.
Mit einer solchen Stabilisierung der Entscheidungsschwelle gegenüber Temperaturänderungen des Chips selbst wird indessen nicht etwaigen Abweichungen der Eingangssignale als solche von ihrem Soll-Verlauf Rechnung getragen; hierzu zeigt aber die Erfindung einen Weg.

Es sei außerdem bemerkt, daß es im Zusammenhang mit einer Abtastung von graphischen Vorlagen und Umsetzung des Abtastsignals in ein Digitalsignal bekannt ist, zu einer von Variationen eines Hintergrundsignals und/oder der Eingangssignalamplitude u./o. -dauer unabhängigen Signaldetektion von im Hintergrundsignal enthaltenen kleinen Eingangssignalimpulsen im Signalweg eine Differenzschaltung und einen ihr nachfolgenden, hochverstärkenden Komparator vorzusehen, dessen Ausgang über einen einen Begrenzer, eine Mittelwertschaltung und eine mit ihrem zweiten Eingang an einer Referenzspannungsquelle liegende weitere Differenzschaltung aufweisenden Gegenkopplungspfad mit dem zweiten Eingang der erstgenannten Differenzschaltung verbunden ist (US-A 42 63 555); nähere Berührungspunkte mit der vorliegenden Erfindung sind nicht gegeben.

Es sei ferner bemerkt, daß es (aus US-A 4 488 064) in einer integrierten Schaltungsanordnung mit einem Si-Baustein und einem GaAs-Baustein bekannt ist, zur Vermeidung einer gesonderten Stromversorgung des GaAs-Bausteins im Si-Baustein zusätzlich zu den mit Digitalsignalen beaufschlagten Verknüpfungsgliedern einen mit einem Referenzpotential beaufschlagten Inverter vorzusehen, dessen Ausgangspotential das negative Speisepotential für den GaAs-Baustein bildet; Probleme einer etwa spannungs- oder temperaturbedingten Abweichung der Digitalsignale von ihrem Soll-Verlauf, einer Kompensation solcher Abweichung und einer entsprechend gesteuerten Verschiebung von steuerbaren Schaltschwellen der Digital-signal-Eingangsschaltungen des GaAs-Bausteins werden dabei nicht angesprochen.

Schließlich sei bemerkt, daß ein Schalttransistor in Gateschaltung, dessen Gate-Elektrode von einer Steuerschaltung angesteuert wird, an sich (z.B. aus IBM Techn. Discl.Bull. 11(1969)10, 1272-1273 als Bestandteil eines Bipolar-MOSFET-Pegelkonverters) bekannt ist.

Hingewiesen sei an dieser Stelle auch noch auf die Zeitrang gleiche EP-Patent-anmeldung EP-A1-0 239 844, die sich auf eine zur Zeitregeneration von Digitalsignalen geeignete Schaltungsanordnung mit einer Korrekturschaltung und einer zugehörigen, eine Tiefpaßschaltung enthaltenden Steuerschaltung bezieht, bei der zur Zeitregeneration von in einem gleichstromfreien Code codierten Breitband-Digitalsignalen in Breitband-Digitalsignal-Vermittlungs- u./o. Übertragungssystemen in den Signalweg ein einen Digitalsignaleingang und einen Steuereingang aufweisendes Korrekturglied, in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann, eingefügt ist, zu dessen Steuereingang eine eine entsprechende Gleichstromkomponente ermittelnde Steuerschaltung mit einer vom Digitalsignal beaufschlagten Begrenzerschaltung und einer ihr nachgeschalteten Tiefpaßschaltung führt, wobei in dem Korrekturglied das Digitalsignal nach Maßgabe jeder im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfährt.

Um nun auf die Erfindung zurückzukommen, so kann in weiterer Ausgestaltung der Erfindung die Begrenzerschaltung mit einer Inverterschaltung gebildet sein; die Tiefpaßschaltung, die einfach mit einem RC-Glied gebildet sein kann, kann mit den Steuereingängen der Eingangsschaltungen in weiterer Ausgestaltung der Erfindung über einen Regelverstärker verbunden sein, vorzugsweise über einen an seinem zweiten Eingang mit einem Bezugssignal beaufschlagten Differenzverstärker.

Weitere Besonderheiten der Erfindung sind aus der nachfolgenden näheren Erläuterung der Erfindung anhand der Zeichnung ersichtlich. Dabei zeigen

FIG 1 schematisch ein Ausführungsbeispiel einer Schaltungsanordnung gemäß der Erfindung und

FIG 2 ein solches Ausführungsbeispiel in seinen schaltungstechnischen Einzelheiten.

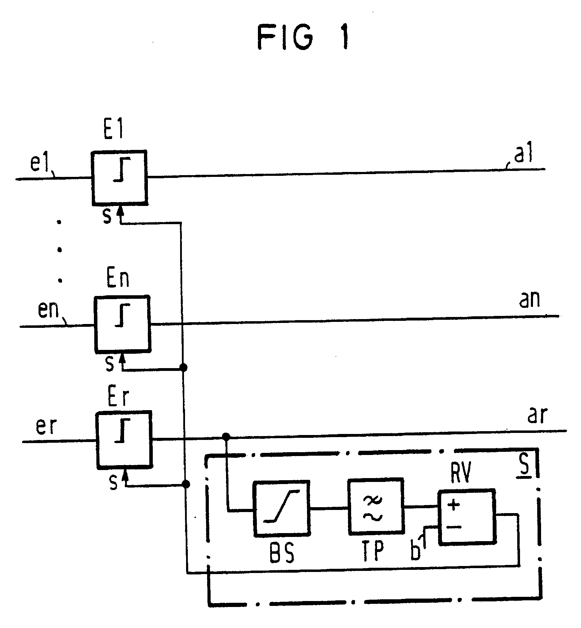

Das in FIG 1 schematisch dargestellte Ausführungsbeispiel einer Schaltungsanordnung zur Digitalsignal-Ansteuerung eines IC-Bausteins gemäß der Erfindung weist für die einzelnen den IC-Baustein an Eingangsleitungen el-al,...,en-an, er-ar ansteuernden Digitalsignale untereinander gleichar-

tige Eingangsschaltungen EI,...En, Er auf, die über Steuereingänge s in ihrer jeweiligen Schaltschwelle einstellbar sind. Zu diesen Steuereingängen s führt eine allen Eingangsschaltungen EI,...En, Er gemeinsame Steuerschaltung S, die mit einer Begrenzerschaltung BS und einer ihr nachgeschalteten Tiefpaßschaltung TP aufgebaut ist; die Tiefpaßschaltung TP führt über einen Regelverstärker RV, im Beispiel einen an seinem zweiten Eingang mit einem Bezugssignal (b) beaufschlagten Differenzverstärker, zu den Steuereingängen s der Eingangsschaltungen EI,...,En, Er. Eingangsseitig ist die Steuerschaltung S mit einer der Eingangsschaltungen, im Beispiel mit der Eingangsschaltung Er, verbunden, wobei davon ausgegangen wird, daß das am Schaltungseingang er auftretende Digitalsignal in seinem Signalpegel und dessen - etwa durch Speisespannungs- oder Temperaturänderungen bedingten - Verlagerungen auch für die an den übrigen Signaleingängen el,...en auftretenden Digitalsignale repräsentativ ist; nach Maßgabe der in diesem repräsentativen Digitalsignal auftretenden Gleichstromkomponente wird von der Steuerschaltung S in den von ihr gesteuerten Eingangsschaltungen EI,...En, Er deren jeweilige Schaltschwelle eingestellt:

Im Sollzustand des Schaltungssystems möge das repräsentative Digitalsignal ein bestimmtes Tastverhältnis aufweisen, d.h. ein bestimmtes Verhältnis der Dauer eines "High"-Bits zu der Dauer eines "Low"-Bits, aufgrund dessen das in der Begrenzerschaltung BS begrenzte Digitalsignal eine bestimmte Gleichstromkomponente aufweist, die von der Tiefpaßschaltung TP herausgefiltert wird; diese Gleichstromkomponente kann - bei einem Tastverhältnis 1:1 - auch von der Größe Null sein. Das Ausgangssignal der Tiefpaßschaltung TP wird im Regelverstärker RV mit dem nach Maßgabe des Tastverhältnisses des repräsentativen Digitalsignals und der Eigenschaften der Begrenzungsschaltung BS festgelegten Bezugssignal (b) in Beziehung gesetzt, so daß das am Ausgang des Regelverstärkers RV und damit an den Steuereingängen s der Eingangsschaltungen EI,...,En, Er auftretende Steuersignal in den Eingangsschaltungen die jeweilige Schaltschwelle gerade auf eine dem Signalpegel-Sollwert entsprechende Höhe einstellt.

Ändert sich - beispielsweise aufgrund einer Änderung einer Versorgungsspannung im Schaltungssystem - die Lage des repräsentativen Digitalsignals, so führt dessen endliche Flankensteilheit beim Durchlaufen der Ansprechschwelle in der Eingangsschaltung Er dazu, daß - bei einer Pegelanhebung - die "High"-Bit-Dauer verlängert und die "Low"-Bit-Dauer verkürzt wird bzw. daß umgekehrt - bei einer Pegelabssenkung - die "High"-Bit-Dauer verkürzt und die "Low"-Bit-Dauer verlängert wird. Dies bewirkt eine entsprechende Änderung des Ausgangssignals der Tiefpaßschaltung TP und damit auch des über den Regelverstärker RV den Steuereingängen s der Eingangsschaltungen EI,...,En, Er zugeführten Steuersignals mit der Folge, daß die jeweilige Schaltschwelle entsprechend angehoben bzw. abgesenkt wird, so daß die Lageänderung des Digitalsignals durch die Lageänderung der Schaltschwelle kompensiert wird.

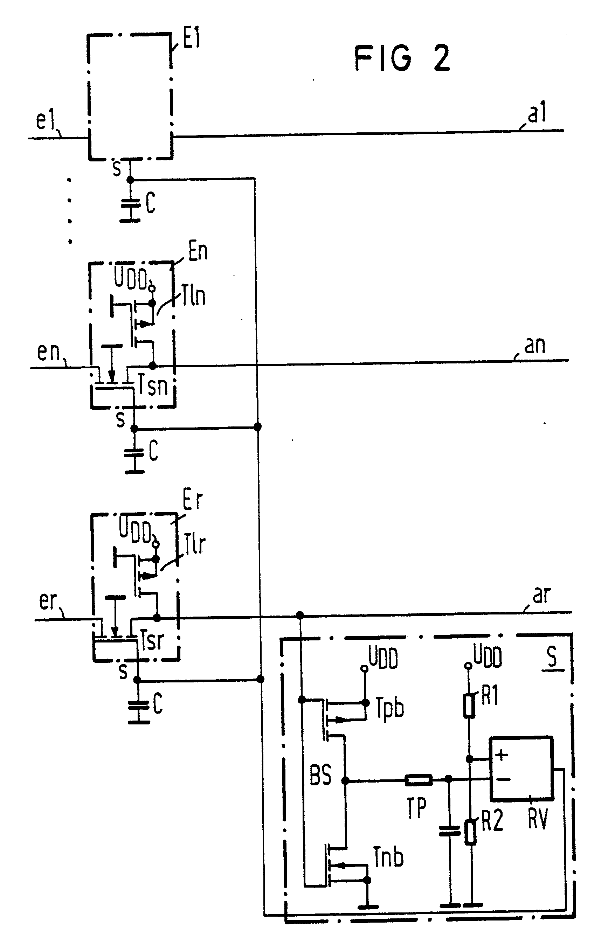

Wie die Eingangsschaltungen E und die Steuerschaltung S im einzelnen realisiert sein können, wird aus FIG 2 ersichtlich. Im dort dargestellten Ausführungsbeispiel einer Schaltungsanordnung gemäß der Erfindung sind Eingangsschaltungen E und Begrenzerschaltung BS in C-MOS-Technik realisiert. Gemäß FIG 2 sind die Eingangsschaltungen ...,En jeweils mit einem in den jeweiligen Digitalsignalweg ...,en-an eingefügten Schalttransistor ...,Tsn in Gateschaltung gebildet, zu dessen Gate-Elektrode die gemeinsame Steuerschaltung S führt und der ausgangsseitig jeweils über einen Lasttransistor ...,Tln an einer Speisespannungsquelle $U_{DD}$ - (beispielsweise $+U_{DD}$) liegt; dabei ist im Ausführungsbeispiel der Schalttransistor (Ts) ein n-Kanal-Anreicherungs-Feldeffekttransistor und der - zusammen mit der Speisepotentialquelle $U_{DD}$ eine Stromquellenschaltung bildende - Lasttransistor (Tl) ein p-Kanal-Anreicherungs-Feldeffekttransistor. In entsprechender Weise ist die Schwellwertschaltung Er mit einem in den von dem repräsentativen Digitalsignal durchlaufenen Digitalsignalweg er-ar eingefügten Schalttransistor Tsr in Gateschaltung gebildet, zu dessen Gate-Elektrode die Steuerschaltung S führt und der ausgangsseitig über einen Lasttransistor Tlr an der Speisepotentialquelle $U_{DD}$ liegt.

Die Begrenzerschaltung BS ist mit einer zwei Transistoren Tpb, Tnb aufweisenden C-MOS-Inverterschaltung gebildet; wie in FIG 2 weiter angedeutet ist, kann die Tiefpaßschaltung TP mit einem einfachen RC-Glied gebildet sein. Der Tiefpaßschaltung TP ist im Ausführungsbeispiel gemäß FIG 2 ein Regelverstärker in Form eines Differenzverstärkers RV nachgeschaltet, wobei durch Anschluß an den invertierenden Eingang (-) des Differenzverstärkers RV der in der Begrenzerschaltung BS bewirkten Digitalsignal-Invertierung Rechnung getragen wird. An seinem nichtinvertierenden Eingang (+) wird im Ausführungsbeispiel gemäß FIG 2 dem Differenzverstärker RV eine Bezugsspannung zugeführt, die aus der Speisespannung $U_{DD}$ mittels eines Spannungsteilers aus ohmschen Widerständen R1,R2 gewonnen wird, der nach Maßgabe des im Sollzustand des Schaltungssystems gegebenen Tastverhältnisses des repräsentativen Digitalsignals bemessen ist.

In der Schaltungsanordnung gemäß FIG 2 möge an den einzelnen Signalweg-Eingängen el,...,en,er jeweils im Digitalsignalzustand "High" ein Potential von beispielsweise etwa - 1 V und im Digitalsignalzustand "Low" ein Potential von etwa -2 V herrschen; die Digitalsignale können dabei z.B. in einem gleichstromfreien Code codiert sein, wobei dann statistisch, d.h. über eine hinreichend lange Zeit gesehen, die beiden Potentialzustände gleich lange auftreten sollten. An den Steuereingängen s der Eingangsschaltungen El,...,En,Er und damit an der Gate-Elektrode des jeweiligen Schalttransistors ...,Tsn,Tsr der Eingangsschaltung möge dabei von der Steuerschaltung S her ein Steuerpotential von beispielsweise etwa + 0,4 V anliegen, wobei die Schaltschwelle des mit dem Lasttransistor T1 verbundenen Schalttransistors Ts um eine Schwellenspannung von beispeilsweise etwa - 1,8 V darunter liegen möge.

Bei am Eingang er herrschendem Signalzustand "High" ist dann in der Eingangsschaltung Er der Schalttransistor Tsr nichtleitend, und am Eingang der Begrenzerschaltung BS, deren Schaltschwelle etwa bei + 1 V liegen möge, bildet sich ein Potential von im Beispiel etwa + 3,3 V aus, aufgrund dessen der p-Kanal-Transistor Tpb der C-MOS-Inverterschaltung nichtleitend (oder allenfalls sehr schwach leitend) und der n-Kanal-Transistor tnb (gut) leitend ist;

beim Digitalsignalzustand "Low" ist in der Eingangsschaltung Er der Schalttransistor Tsr leitend, und am Eingang der Begrenzerschaltung BS bildet sich ein Potential von im Beispiel etwa - 1,2 V aus, aufgrund dessen der p-Kanal-Transistor Tpb der C-MOS-Inverterschaltung leitend und der n-Kanal-Transistor Tnb nichtleitend ist.

Über die Tiefpaßschaltung Tp gelangt ein dem zeitlichen Mittelwert des am Begrenzerausgang auftretenden Digitalsignals zu dem einen Eingang (-) des Differenzverstärkers RV, dessen anderer Eingang (+) mit dem Bezugssignal beaufschlagt ist und von dessen Ausgang bei einem von Digitalsignal (im Beispiel eines gleichstromfreien Codes) eingehaltenen Tastverhältnis 1:1 das erwähnte Steuerpotential von im Beispiel + 0,4 V abgegeben werden möge.

Weicht das Tastverhältnis des am Signaleingang er auftretenden, für die übrigen Digitalsignale repräsentativen Digitalsignals vom Verhältnis 1:1 (im Beispiel einer gleichstromfreien Codierung) ab, d.h. tritt, über eine hinreichend lange Zeit gesehen, am Signalweg-Eingang er der Signalzustand "High" länger (bzw. kürzer) als der Signalzustand "Low" - und demzufolge am Begrenzerausgang der Signalzustand "Low" länger (bzw. kürzer) als der Signalzustand "High" - auf, so kommt es zu einer entsprechenden Absenkung (bzw. Anhebung) des Ausgangssignals der Tiefpaßschaltung TP und damit zu einer entsprechenden Erhöhung (bzw. Verringerung) der Eingangssignaldifferenz beim Differenzverstärker RV; dies bewirkt eine entsprechende Anhebung (bzw. Absenkung) des vom Ausgang des Differenzverstärkers RV den Steuereingängen s der Eingangsschaltungen El,...,En,Er zugeführten Potentials um einen Betrag von beispielsweise 0,2 V mit der Folge, daß dementsprechend die Schaltschwelle der C-MOS-Eingangsschaltungen ...,En,Er angehoben (bzw. herabgesetzt) wird; durch diese Lageänderung der jeweiligen Schaltschwelle wird die Lageänderung des jeweiligen Digitalsignals kompensiert.

Abschließend sei noch darauf hingewiesen, daß in der Schaltungsanordnung nach FIG 2 die einzelnen Steuereingänge s durch Kondensatoren C abgeblockt sind, um Kopplungen zwischen den einzelnen Signalwegen ..., en-an, er-ar zu vermeiden.

## Patentansprüche

1. Zur Ansteuerung eines IC-Bausteins durch ein Ausgangs-Digitalsignal eines anderen IC-Bausteins geeignete Schaltungsanordnung mit einer Eingangsschaltung (Er), deren jeweilige Schaltschwelle, von einer Steuerschaltung (S) mit einer von einem Digitalsignal beaufschlagten Begrenzerschaltung (BS) und einer ihr nachgeschalteten, zu dem Steuereingang (s) der Eingangsschaltung (Er) führenden Tiefpaßschaltung (TP) gesteuert, nach Maßgabe der in dem Digitalsignal auftretenden Gleichstromkomponente eingestellt wird,
   **dadurch gekennzeichnet,**
   daß zur Ansteuerung des IC-Bausteins durch eine Mehrzahl solcher Digitalsignale für die einzelnen Digitalsignale eine entsprechende Mehrzahl untereinander gleichartiger Eingangsschaltungen (Er, En) vorgesehen ist, die jeweils mit einem in den Digitalsignalweg (e - a) eingefügten, mit einem Lasttransistor (T1) verbundenen Schalttransistor (Ts) in Gateschaltung gebildet sind, zu dessen Gate-Elektrode eine gemeinsame Steuerschaltung (S) führt, deren Begrenzerschaltung von einem in seinem Signalpegel auch für die übrigen Digitalsignale repräsentativen Digitalsignal beaufschlagt ist.

2. Schaltungsanordnung nach Anspruch 1,
   **dadurch gekennzeichnet,**
   daß die Begrenzerschaltung (BS) mit einer Inverterschaltung (Tpb, Tnb) gebildet ist.

3. Schaltungsanordnung nach einem der Ansprüche 1 bis 2,
   **dadurch gekennzeichnet,**
   daß die Tiefpaßschaltung (TP) mit einem RC-Glied gebildet ist.

4. Schaltungsanordnung nach einem der Ansprüche 1 bis 3,
**dadurch gekennzeichnet,**
daß die Tiefpaßschaltung (TP) über einen Regelverstärker (RV) mit den Steuereingängen (s) der Eingangsschaltungen (Er, En) verbunden ist.

5. Schaltungsanordnung nach Anspruch 4,
**dadurch gekennzeichnet,**
daß der Regelverstärker ein an seinem zweiten Eingang mit einem Bezugssignal (b) beaufschlagter Differenzverstärker ist.

## Claims

1. Circuit arrangement suitable for driving an IC unit by means of a digital output signal of another IC unit, having an input circuit (Er), whose actual switching threshold is controlled by a control circuit (S) having a limiter circuit (BS) to which a digital signal is applied and a low-pass filter connected downstream therefrom leading to the control input (s) of the input circuit (Er), which input circuit (Er) is adjusted according to the d.c. current component occurring in the digital signal, characterised in that an appropriate multiplicity of mutually identical input circuits (Er, En) is provided for the individual digital signals, for driving the IC unit by means of a multiplicity of such digital signals, which input circuits are in each case formed with a switching transistor (Ts) in a gate circuit, inserted in the digital signal path (e - a) and connected to the load transistor (T1), to the gate electrode of which switching transistor a common control circuit (S) leads, to the limiter circuit of which is applied a digital signal whose signal level is also representative of the other digital signals.

2. Circuit arrangement according to Claim 1, characterised in that the limiter circuit (BS) is formed with an inverter circuit (Tpb, Tnb).

3. Circuit arrangement according to one of Claims 1 to 2, characterised in that the low-pass circuit (TP) is formed with an RC element.

4. Circuit arrangement according to one of Claims 1 to 3, characterised in that the low-pass circuit (TP) is connected via a control amplifier (RV) to the control inputs (s) of the input circuits (Er, En).

5. Circuit arrangement according to Claim 4, characterised in that the control amplifier is a differential amplifier, to the second input of which a reference signal (b) is applied.

## Revendications

1. Montage convenant pour la commande d'un module à circuits intégrés par un signal numérique de sortie d'un autre module à circuits intégrés et comportant un circuit d'entrée (Er), dont le seuil respectif de commutation est réglé en fonction de la composante de courant continu apparaissant dans le signal numérique, d'une manière commandée par un dispositif de commande (S) comportant un circuit limiteur (BS) chargé par un signal numérique, et un circuit formant filtre passe-bas (TP) branché en aval du circuit limiteur et raccordé à l'entrée de commande (s) du circuit d'entrée (Er), caractérisé par le fait que pour la commande du module à circuits intégrés par une multiplicité de tels signaux numériques, il est prévu pour les différents signaux numériques une multiplicité correspondante de circuits d'entrée identiques (Er,En), qui sont formés respectivement d'un transistor de commutation (Ts) inséré dans une voie (e-a) de transmission des signaux numériques et raccordé à un transistor de charge (T1) et branché selon un montage en grille commune et à l'électrode de grille duquel est raccordé un circuit commun de commande (s), dont le circuit limiteur est chargé par un signal numérique dont le niveau est également représentatif de celui des autres signaux numériques.

2. Montage suivant la revendication 1, caractérisé par le fait que le circuit limiteur (BS) est formé par un circuit inverseur (Tpb, Tnb).

3. Montage suivant les revendications 1 et 2, caractérisé par le fait que le circuit passe-bas (TP) est formé par un circuit RC.

4. Montage suivant l'une des revendications 1 à 3, caractérisé par le fait que le circuit de filtre passe-bas (TP) est raccordé par l'intermédiaire d'un amplificateur de régulation (RV) aux entrées de commande (s) du circuit d'entrée (Er,En).

5. Montage suivant la revendication 4, caractérisé par le fait que l'amplificateur de régulation est un amplificateur différentiel dont la seconde entrée est chargée par un signal de référence (b).

# FIG 1

FIG 2